# EUROPEAN PATENT APPLICATION

(11) **EP 4 667 950 A1**
(43) Date of publication of application: **24.12.2025**
(21) Application number: 24183792.1
(22) Date of filing: 21.06.2024
(51) Int. Cl.: G01R 31/00, G01R 31/52, B60L 3/00

(54) **LEAKAGE DETECTION SYSTEM**

(71) Applicant: Hamilton Sundstrand Corporation, Charlotte, NC 28217-4578 (US)
(72) Inventor: FERNANDEZ-MATTOS, Rodrigo, B90 4JJ Solihull (GB); SHAH, Mital, HA3 0NH Harrow (GB); TULLET, James Thomas Marshall, B13 9JS Birmingham (GB)
(74) Representative: Dehns

(57) **Abstract**

A leakage detection system for an isolated earth system (2) of an aircraft, the leakage detection system includes a common bus (4), a plurality of switches (S1, S2, S3, S4) and at least one connector (9). The at least one connector (9) is arranged to connect at least one of the plurality of switches (S1, S2, S3, S4) to at least one component (12, 14, 16) of the isolated earth system (2). At least one of the plurality of switches (S1, S2, S3, S4) is arranged to control the draw of power from the common bus (4). The leakage detection system includes a switch driver (8) arranged to control the plurality of switches (S1, S2, S3, S4) between a plurality of configurations. The leakage detection system is arranged to determine a location of a leakage using a measurement of the insulation monitoring device (10).

## Description

### FIELD

The present disclosure relates to a leakage detection system of an aircraft, in particular leakage detection system for an isolated earth (IT) system of an aircraft that includes an insulation monitoring device (IMD) configured to detect changes in insulation of the IT system.

### BACKGROUND

Increasingly, aircraft power systems are powered by electric and hybrid motors. A high voltage power supply may be used the power system and the power system may include a network of connections between the power supply, the support component(s) and the electric motor(s). The power system may use an isolated earth (IT) system to protect these high voltage connections. It may be important to detect changes in insulation of the IT system, as leakage from the IT system may impact other systems in the aircraft, which may lead to failures in these systems.

It is desired to provide an improved leakage detection system for IT systems in aircraft.

### SUMMARY

The disclosure provides a leakage detection system for an isolated earth system of an aircraft, the leakage detection system comprising:
a common bus;
a plurality of switches;
a chassis ground;
at least one connector;

wherein the at least one connector is arranged to connect at least one of the plurality of switches to at least one component of the isolated earth system;
wherein at least one of the plurality of switches is arranged to control the draw of power from the common bus to the at least one connector;
   a switch driver;
wherein the switch driver is arranged to control the plurality of switches between a plurality of configurations; and
   an insulation monitoring device;
wherein the insulation monitoring device is arranged in communication with the common bus and the chassis ground;
wherein the insulation monitoring device is arranged to measure a voltage representative of a voltage between the common bus and the chassis ground and/or a current representative of a current that flows between the chassis ground and the common bus, when the plurality of switches is in each of the plurality of configurations; and
wherein the leakage detection system is arranged to determine a location of a leakage using the voltage representative of the voltage between the common bus and the chassis ground and/or the current representative of the current that flows between the chassis ground and the common bus measured by the insulation monitoring device for at least one of the plurality of configurations of the plurality of switches.

The disclosure also provides a method of operating a leakage detection system for an isolated earth system of an aircraft, wherein the leakage detection system comprises:
a common bus;
a plurality of switches;
a chassis ground;
at least one connector;
   wherein the at least one connector is arranged to connect at least one of the plurality of switches to at least one component of the isolated earth system;
a switch driver; and
an insulation monitoring device;
   wherein the insulation monitoring device is arranged in communication with the common bus and the chassis ground;
wherein the method comprises:
   controlling the draw of power from the common bus to the at least one connector using at least one of the plurality of switches;
   controlling the plurality of switches between a plurality of configurations using the switch driver;
   measuring a voltage representative of the voltage between the common bus and the chassis ground and/or a current representative of a current that flows between the chassis ground and the common bus using the insulation monitoring device, when the plurality of switches is in each of the plurality of configurations; and
   determining a location of a leakage using the voltage representative of the voltage between the common bus and the chassis ground and/or the current representative of the current that flows between the chassis ground and the common bus measured by insulation monitoring device for at least one of the plurality of configurations of the plurality of switches.

It will be appreciated that all of the features described herein relating to the leakage detection system apply equally to the method of operating the leakage detection system, and vice versa.

The switch driver is arranged to control the plurality of switches between a plurality of configurations. Each of the plurality of configurations may be a particular arrangement (e.g. combination) of the plurality of switches in a set of conditions, e.g. the plurality of configurations may be a plurality of combinations of the conditions of the plurality of switches (e.g. each configuration may be a respective different combination of the conditions of the plurality of switches). Each of the plurality of switches may have an "on" condition and an "off" condition. The plurality of switches may control the delivery of power from the common bus to the at least one connector (e.g. from a power source via the common bus to the at least one connector).

The at least one connector is arranged to connect at least one of the plurality of switches to at least one component of the isolated earth system. In some examples, the leakage detection system comprises a plurality of connectors for connecting to plurality of components (e.g. each connector may be arranged for connecting to a respective component). In some examples, the plurality of switches are arranged to control the draw of power from the common bus to the plurality of connectors (e.g. respectively).

By arranging the switch driver to control the plurality of switches between a plurality of configurations, the switch driver may control the delivery of power from the common bus to the connector(s) and the component(s) of the isolated earth system.

The connector(s) may be connected to the common bus. Thus, the component(s) may be connected to the common bus via the connector(s) (e.g. respectively). The connector(s) may be connected to the common bus via the plurality of switches (e.g. respectively).

The insulation monitoring device is arranged in communication with (e.g. connected between) the common bus and the chassis ground. The insulation monitoring device is arranged to measure the voltage representative of the voltage between the common bus and the chassis ground and/or the current representative of the current that flows between the chassis ground and the common bus when the plurality of switches is in each of the plurality of configurations. By arranging the insulation monitoring device to measure the voltage representative of the voltage between the common bus and the chassis ground and/or the current representative of the current that flows between the chassis ground and the common bus, a leakage may be detected. By controlling (e.g. each of) the plurality of switches with the switch driver, the switch driver and the insulation monitoring device may be used to determine the location of a leakage in an isolated earth system.

In some examples, the insulation monitoring device is arranged to detect a change in the voltage representative of the voltage between the common bus and the chassis ground and/or a change in the current representative of the current that flows between the chassis ground and the common bus, when the plurality of switches is in one of the plurality of configurations. In some examples, the insulation monitoring device is arranged to detect a change in the voltage representative of the voltage between the common bus and the chassis ground and/or a change in the current representative of the current that flows between the chassis ground and the common bus, when the plurality of switches changes from one of the plurality of configurations to another of the plurality of configurations. By arranging the insulation monitoring device to detect a change in the voltage representative of the voltage between the common bus and the chassis ground and/or the current representative of the current that flows between the chassis ground and the common bus, a leakage may be detected.

The voltage representative of the voltage between the common bus and the chassis ground may be due to the resistance of the insulation monitoring device. In some examples, the insulation monitoring device comprises an insulation monitoring device resistor. In some examples, the resistance of the insulation monitoring device resistor is arranged to be varied. In some examples, the insulation monitoring device comprises a potentiometer. In some examples, the potentiometer is arranged to measure the voltage representative of the voltage between the common bus and the chassis ground.

The current representative of the current that flows between the common bus and the chassis ground may flow when there is a leakage in the insulation of at least one of the at least one components. By arranging the insulation monitoring device to be in communication with the common bus and the chassis ground, the insulation monitoring device may complete the circuit between the common bus and the chassis ground when there is a leakage, and a current representative of the current that flows between the common bus and the chassis ground may flow through the insulation monitoring device.

The current representative of the current that flows between the common bus and the chassis ground may depend on the resistance of the insulation monitoring device. The current representative of the current that flows between the common bus and the chassis ground, may depend on the resistance of the chassis. In some examples, the insulation monitoring device comprises an ammeter. The resistance of the insulation monitoring device may be chosen (e.g. varied) appropriately to result in a current representative of the current that flows between the common bus and the chassis ground that may be measured by the ammeter.

In some examples, the insulation monitoring device comprises an internal sense resistor. By providing an internal sense resistor, the current representative of the current that flows between the common bus and the chassis ground may be measured through the internal sense resistor. By providing an internal sense resistor, the voltage representative of the voltage between the common bus and the chassis ground may be measured across the internal sense resistor.

In some examples, the insulation monitoring device is arranged to apply a potential to the common bus (e.g. a common mode voltage). By applying a voltage to the common bus, the insulation monitoring device may measure a current, for example, the current representative of the current that flows between the chassis ground and the common bus. In some examples, the insulation monitoring device is arranged to measure a change in the current, for example, a change in the current representative of the current that flows between the chassis ground and the common bus.

In some examples, the insulation monitoring device may be arranged to continuously apply a voltage to the common bus. In some examples, the insulation monitoring device may be arranged to continuously apply a time varying voltage to the common bus. In some examples, the insulation monitoring device may be arranged to continuously apply a square wave voltage to the common bus. By continuously applying a voltage between the common bus and the chassis ground, a leakage may be determined by a change in current measured by the insulation monitoring device.

In some examples, the isolated earth system comprises a hybrid electric propulsion system. In some examples, the isolated earth system is an AC system.

In some examples, power is arranged to be supplied to the common bus by a battery. In some examples, the at least one component of isolated earth system comprises a battery management system (e.g. comprising a battery). In some examples, the at least one component of isolated earth system comprises an electric motor. In some examples, the at least one component of isolated earth system comprises an aircraft load.

In some examples, the leakage detection system comprises a controller. In some examples, the controller is arranged to communicate with the switch driver, e.g. to determine the location of a leakage. The controller may be arranged to control the switch driver. In some examples, the controller may be arranged to communicate with the insulation monitoring device, e.g. to determine the location of a leakage.

In some examples, the controller comprises a multiplexer. The multiplexer may be arranged to (e.g. determine and) set the plurality of configurations, to determine the location of a leakage. In some examples, the controller is arranged to use the plurality of configurations provided by the multiplexer to control the switch driver, to determine the location of a leakage. In some examples, the controller is arranged to control the switch driver to control the plurality of switches between (e.g. each of) the plurality of configurations when the insulation monitoring device detects a change in the voltage representative of the voltage between the common bus and the chassis ground and/or a change in the current representative of the current that flows between the chassis ground and the common bus.

For example, the insulation monitoring device may be arranged to detect a change in the voltage representative of the voltage between the common bus and the chassis ground and/or a change in the current representative of the current that flows between the chassis ground and the common bus (e.g. when the plurality of switches is in one of the plurality of configurations) and then cycle through the plurality of configurations to determine the location of a leakage. Thus, the insulation monitoring device may be arranged to communicate with the controller to signal the change in the voltage representative of the voltage between the common bus and the chassis ground and/or the current representative of the current that flows between the chassis ground and the common bus to the controller, e.g. so that the controller can control the switch driver accordingly.

In some examples, there is a first threshold potential measured by the insulation monitoring device at which maintenance of the isolated earth system is determined to be required (e.g. by the controller). In some examples, there is second a threshold potential measured by the insulation monitoring device at which the isolated earth system is determined to be unsafe (e.g. by the controller).

In some examples, the leakage detection system is arranged to perform a check for a leakage over a period of time. The period of time may depend on the impedance and/or capacitance of the isolated earth system and the chassis ground. In some examples, the leakage detection system is arranged to perform the check for a leakage during initialisation of the aircraft. In some examples, the leakage detection system is arranged to perform the check for a leakage during a flight. In some examples, the check for a leakage is arranged to occur between 1s and 100s.

In some examples, the leakage detection system comprises an electric motor. The electric motor may be powered via the common bus. In some examples, the leakage detection system comprises a motor control unit, e.g. arranged to control the electric motor. In some examples, the electric motor is powered by an AC supply. In some examples, the motor control unit comprises a plurality of motor control switches. The motor control switches may be arranged to control the delivery of power from the common bus to the electric motor. By arranging the motor control switches to control the delivery of power from the common bus to the electric motor, the electric motor may be powered by an AC supply. In some examples, the switch driver may be arranged to control the plurality of motor control switches. In some examples, the switch driver, insulation monitoring device and plurality of motor control switches may be arranged to determine if the location of a leakage is in the electric motor or an associated electric motor phase.

In some examples, the leakage detection system is arranged to detect symmetrical and asymmetrical leakages in the isolated earth system.

In some examples, the controller is arranged to isolate the component of the isolated earth system where the leakage is found. In some examples, the controller is arranged to use the switch driver to configure the plurality of switches to remove power from the common bus to the component where a leakage is found. By using the controller to stop the supply of power to components where a leakage is found, the isolated earth system may continue to operate safely with at least one leakage.

In some examples, the leakage detection system comprises an interface system. In some examples, the interface system is arranged to communicate with the controller. In some examples, the interface system is arranged to display the location of a leakage in the isolated earth system. In some examples, the interface system is arranged to display the first threshold potential. In some examples, the interface system is arranged to display the second threshold potential. By arranging the interface system to display the location of a leakage, the first threshold potential, or the second threshold potential, it may be easier for a maintenance person to identify the state of the isolated earth system.

### BRIEF DESCRIPTION OF DRAWINGS

One or more non-limiting examples will now be described, by way of example only, and with reference to the accompanying figures in which;
Figure 1 shows a schematic view of an electrical portion of a hybrid electric propulsion system;
Figure 2 shows an example multiplexer;
Figure 3 shows graphs of potential and response; and
Figure 4 shows a schematic view of a motor control unit.

### DETAILED DESCRIPTION

The present disclosure relates to isolated earth (IT) systems of an aircraft. IT systems may be implemented in a variety of electronic systems in aircraft. An example of an IT system in an aircraft will be described herein.

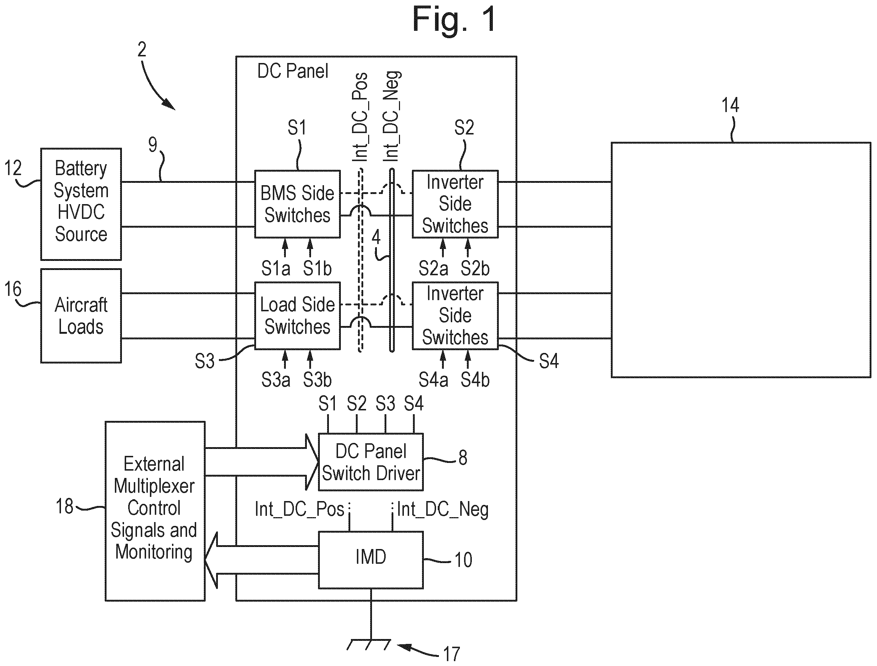

Figure 1 shows a schematic view of an example of an electrical portion of a hybrid electric propulsion (HEP) system 2 in an aircraft. The HEP system 2 is an IT system. The HEP system 2 includes a common voltage bus 4, a plurality of switches 6, a switch driver 8 and an insulation monitoring device 10 (IMD).

The HEP system 2 may also include a battery and a battery management system 12. The battery and battery management system 12 may be arranged to supply power to the common bus 4.

The HEP system 2 also includes at least one connector 9. The connector(s) 9 may connect the plurality of switches S1, S2, S3, S4 to at least one component of the HEP system 2. The at least one component of the HEP system 2 may, for example, be a motor 14, one or more aircraft loads 16 or the battery management system 12. The motor 14 may comprise a motor control unit and an electric motor. The plurality of switches S1, S2, S3, S4 are arranged to control the delivery of power through the common bus 4 to the component(s) of the HEP system 2.

The switch driver 8 is arranged to control the plurality of switches 6 between a plurality of configurations (combinations of the conditions of the plurality of switches 6). By controlling the plurality of switches S1, S2, S3, S4 with the switch driver 8, the delivery of power to the component(s) of the HEP system 2 may be controlled.

The HEP system 2 may also include a controller 18 arranged to communicate with the switch driver 8. By arranging the controller 18 to communicate with the switch driver 8, the controller 18 may control the plurality of switches S1, S2, S3, S4 between a plurality of configurations corresponding to different HEP system 2 conditions, for example, different flight stages.

During normal operation of the HEP system 2, the battery may supply power to the common bus 4. The controller 18 may control the switch driver 8 to configure the plurality of switches S1, S2, S3, S4, which may allow power delivery through the connector(s) 9 to the component(s) of the HEP system 2. The set of conditions of the plurality of switches S1, S2, S3, S4 may be varied during flight, e.g. to control the component(s) of the HEP system 2 at different flight stages.

The insulation monitoring device (IMD) 10 is arranged to be in communication with the common bus 4 and a chassis ground 17. The IMD 10 may be arranged to measure a signal representative of the state of the HEP system 2. The IMD 10 measures a voltage representative of a voltage between the common bus 4 and the chassis ground 17, or the IMD 10 measures a current representative of a current that flows between the chassis ground and the common bus 17.

The IMD 10 may comprise an internal sense resistor through which a current representative of a current between the chassis ground and the common bus flows through. Current may flow through the IMD 10 when there is a leakage in the insulation of a component of the HEP system 2. A leakage in the insulation of the HEP system 2 may make the HEP system 2 unsafe.

The IMD 10 may comprise a potentiometer arranged to measure the voltage representative of the voltage between the common bus 4 and the chassis ground 17. The potentiometer may be arranged to measure the voltage representative of the voltage between the common bus 4 and the chassis ground 17. The potentiometer may be arranged to measure the voltage representative of the voltage of the voltage between the common bus 4 and the chassis ground 17 by measuring a voltage across the internal sense resistor in the IMD 10. By providing an internal sense resistor, an indication of the voltage between the common bus 4 and the chassis ground 17 may be achieved.

The IMD 10 may comprise an ammeter to measure a current representative of the current between the common bus 4 and the chassis ground 17. A current may flow through the IMD 10 when there is a leakage in the HEP system 2, as the IMD 10 is arranged to connect to both the common bus 4 and the chassis ground 17. By arranging the IMD 10 to be in communication with the common bus 4 and the chassis ground 17, the IMD 10 may complete the circuit between the common bus 4 and the chassis ground 17 when there is a leakage and a current representative of the current that flows between the common bus 4 and the chassis ground 17 may flow through the IMD 10.

The IMD 10 may apply a potential to the common bus 4 and measure a current representative of a current that flows between the chassis ground and the common bus 17. By measuring the voltage representative of the voltage between the common bus 4 and the chassis ground 17 and/or the current representative of the current that flows between the chassis ground and the common bus 17 using the IMD 10, a leakage in insulation of a component of the HEP system 2 may be determined.

The IMD 10 may measure a change in a voltage representative of a voltage between the common bus 4 and the chassis ground 17 and/or a change in a current representative of a current that flows between the chassis ground and the common bus 4. By measuring a change in the voltage representative of the voltage between the common bus 4 and the chassis ground 17 and/or a change in the current representative of the current that flows between the chassis ground and the common bus 17, a leakage in insulation of a component of the HEP system 2 may be determined.

The IMD 10 may be arranged to apply a potential to the common bus 4 (e.g. a common mode voltage). By applying a voltage to the common bus 4, the IMD 10 may measure a current, for example, the current representative of the current that flows between the chassis ground 17 and the common bus 4. The IMD 10 may continuously apply a (e.g. time varying) voltage (e.g. square wave) to the common bus 4. By continuously applying a voltage to the common bus 4, a leakage in insulation of a component of the HEP system 2 may be determined by a change in current measured by the IMD 10.

There may be a time taken for the IMD 10 to detect a leakage. The time taken for the IMD 10 to detect a leakage may depend on the impedance and/or capacitance of the HEP system 2 and the chassis ground 17.

The controller 18 may be arranged to communicate with the IMD 10. By arranging the IMD 10 and controller 18 to be in communication, the controller 18 may vary the plurality of switches S1, S2, S3, S4 between the plurality of configurations, (e.g. in response to measurements from the IMD 10) to allow measurements to be taken by the IMD 10 in (e.g. each of) the plurality of configurations.

The controller 18 may include a multiplexer that provides a plurality of configurations for the switch driver 8 to cycle through the plurality of switches S1, S2, S3, S4. By cycling through the (various different combinations of the conditions of the) plurality of switches S1, S2, S3, S4 in the HEP system 2, the location of a leakage may be determined using the IMD 10.

A threshold amount of leakage in the HEP system 2 may be tolerated safety. For example, if there is a single leakage revealed by the IMD 10, the controller 18 may flag that the HEP system 2 needs maintenance. Any leakage above a predetermined threshold value of voltage may lead to wider safety issues in the HEP system 2 and aircraft.

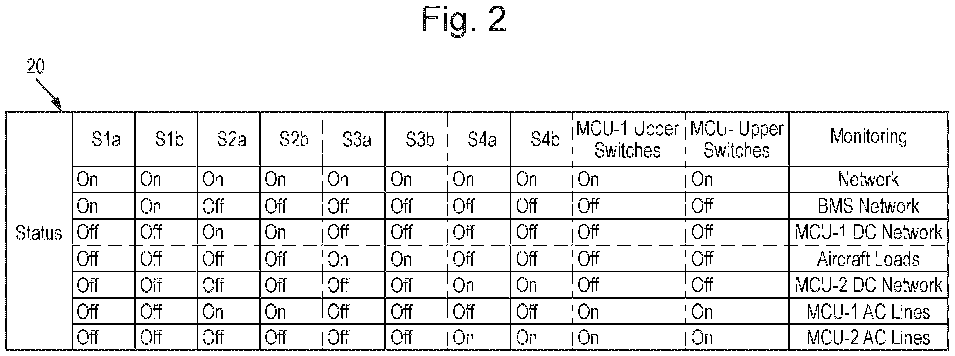

Figure 2 shows an example of plurality of configurations of the multiplexer 20 that the controller 18 may use with the IMD 10 to locate a leakage in the HEP system 2 of Figure 1.

The plurality of configurations of the multiplexer 20 shows an example of the condition of each of the plurality of switches S1, S2, S3, S4 in the plurality of configurations, as may be required to monitor different components of the HEP system 2. By varying the condition of each of the plurality of switches S1, S2, S3, S4, a leakage of power in the HEP system 2 may be located. The controller 18 may use the multiplexer 20 to control the switch driver 8 to configure the plurality of switches S1, S2, S3, S4, so to locate a leakage.

For example, as shown in the first line of Figure 2, the multiplexer 20, controller 18 and switch driver 8 may configure all of the plurality of switches S1, S2, S3, S4 (e.g. to an "on" condition) to deliver power from the common bus 4 to all of the component(s) of the HEP system 2, to determine whether there is a leakage anywhere in the HEP system 2 using the IMD 10.

In another example, as shown in other of the lines of Figure 2, the multiplexer 20, controller 18 and switch driver 8 may configure at least one of the plurality of switches S1, S2, S3, S4 to deliver power from the common bus 4 to only one of the component(s) of the HEP system 2, to determine whether there is a leakage at that particular component of the HEP system 2 to which power is being delivered, using the IMD 10.

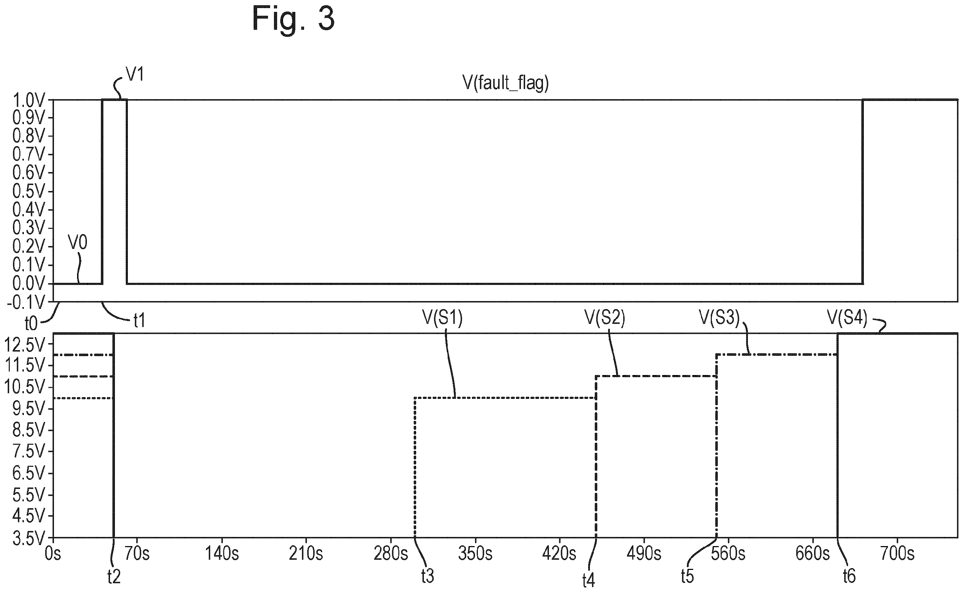

Figure 3 shows an example measurement of a voltage measured by the IMD 10 and an example of the controller 18, switch driver S1, S2, S3, S4 and IMD 10 being used to locate a leakage current in the HEP system 2 of Figure 1.

The voltage measurement in Figure 3 shows the potential (voltage) measured by the IMD 10 against time. At time t0, when each of the plurality of switches S1, S2, S3, S4 is set to the "on" condition, the measured potential by the IMD 10 is V0. At time t1, a leakage enters the HEP system 2. The leakage results in the IMD 10 measuring a leakage potential V1.

The controller 18 and the IMD 10 may be in communication. By measuring a leakage potential V1, the controller 18 may communicate with the switch driver 8 to determine the source of the leakage in the HEP system 2. The controller 18 may use the multiplexer 20 to vary the condition of each of the plurality of switches S1, S2, S3, S4 to determine the source of the leakage in the HEP system 2.

As shown in the lower plot in Figure 3, at time t2, each of the plurality of switches S1, S2, S3, S4 is set to the "off" condition. The potential measured by the IMD 10 returns to V0.

At time t3, switch S1 is turned on and the measured potential by the IMD 10 remains at V0. It may therefore be determined that the leakage is not in the part of the HEP system 2 controlled by switch S1.

At time t4, switch S1 is turned off, switch S2 is turned on and the measured potential by the IMD 10 remains at V0. It may therefore be determined that the leakage is not in the part of the HEP system 2 controlled by switch S2.

At time t5, switch S2 is turned off, switch S3 is turned on and the measured potential by the IMD 10 remains at V0. It may therefore be determined that the leakage is not in the part of the HEP system 2 controlled by switch S3.

At time t6, switch S3 is turned off, switch S4 is turned on and the measured potential by the IMD 10 is V1. It may therefore be determined that the leakage is in the part of the HEP system 2 that is controlled by switch S4.

This information may be used by the controller 18 to indicate that maintenance should be carried out on the part of the HEP system 2 controlled by switch S4.

The application of the multiplexer 20 by the controller 18, with the use of the switch driver 8 and IMD 10 to locate a leakage in the HEP system 2, may occur during the initialisation of a flight or during a flight stage. The plurality of switches S1, S2, S3, S4 may be controlled to determine the location of a leakage without compromising flight safety.

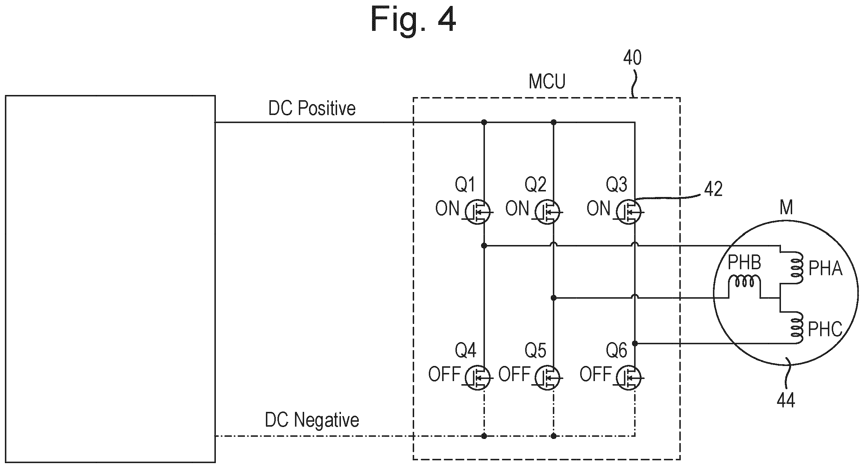

Figure 4 shows schematically a motor control unit 40 (MCU), e.g. as part of the HEP system 2 of Figure 1, for controlling the state of an electric motor 44. Similar to in Figure 1 where the configuration of the plurality of switches S1, S2, S3, S4 may be varied to determine the location of a leakage in the HEP system 2, a plurality of MCU switches 42 in the MCU 40 may be varied to determine the location of a leakage in an electric motor 44 of the HEP system 2.

The MCU 40 and electric motor 44 are arranged to draw power from the common bus 4. The switch driver 8 is arranged to control the condition of the plurality of MCU switches 42 and the IMD 10 may be arranged to measure the voltage representative of the voltage between the common bus 4 and the chassis ground 17 and/or the current representative of the current that flows between the chassis ground and the common bus 17. The IMD 10 may apply a voltage to the common bus 4 and measure a current the current representative of the current that flows between the chassis ground and the common bus 17. By arranging the switch driver 8 to control the conditions of each of the plurality of MCU switches 42 a leakage in the electric motor 44 or an associated motor phase may be determined using the measurements of the IMD 10.

## Claims

1. A leakage detection system for an isolated earth system of an aircraft, the leakage detection system comprising:
a common bus;
a plurality of switches;
a chassis ground;
at least one connector;
wherein the at least one connector is arranged to connect at least one of the plurality of switches to at least one component of the isolated earth system;
wherein at least one of the plurality of switches is arranged to control the draw of power from the common bus to the at least one connector;
a switch driver;
wherein the switch driver is arranged to control the plurality of switches between a plurality of configurations; and
an insulation monitoring device;
wherein the insulation monitoring device is arranged in communication with the common bus and the chassis ground;
wherein the insulation monitoring device is arranged to measure a voltage representative of a voltage between the common bus and the chassis ground and/or a current representative of a current that flows between the chassis ground and the common bus, when the plurality of switches is in each of the plurality of configurations; and
wherein the leakage detection system is arranged to determine a location of a leakage using the voltage representative of the voltage between the common bus and the chassis ground and/or the current representative of the current that flows between the chassis ground and the common bus measured by the insulation monitoring device for at least one of the plurality of configurations of the plurality of switches.

2. The leakage detection system as claimed in claim 1, wherein the insulation monitoring device is arranged to detect a change in the voltage representative of the voltage between the common bus and the chassis ground and/or a change in the current representative of the current that flows between the chassis ground and the common bus, when the plurality of switches is in one of the plurality of configurations.

3. The leakage detection system as claimed in claim 1 or 2, wherein the insulation monitoring device is arranged to detect a change in the voltage representative of the voltage between the common bus and the chassis ground and/or a change in the current representative of the current that flows between the chassis ground and the common bus, when the plurality of switches changes from one of the plurality of configurations to another of the plurality of configurations.

4. The leakage detection system as claimed in any one of the preceding claims, wherein the insulation monitoring device is arranged to apply a voltage to the common bus.

5. The leakage detection system as claimed in any one of the preceding claims, wherein the leakage detection system comprises a controller arranged to control the switch driver.

6. The leakage detection system as claimed in claim 5, wherein the controller is arranged to communicate with the switch driver to determine the location of a leakage.

7. The leakage detection system as claimed in claim 5 or 6, wherein the controller comprises a multiplexer; and
wherein the multiplexer is arranged to set the plurality of configurations of the plurality of switches.

8. The leakage detection system as claimed in claim 5, 6 or 7, wherein the controller is arranged to communicate with the insulation monitoring device.

9. The leakage detection system as claimed in any one of claims 5 to 8, wherein the controller is arranged to isolate the component of the isolated earth system where the leakage is found.

10. The leakage detection system as claimed in any one of the preceding claims, wherein the insulation monitoring device is arranged to measure the voltage representative of the voltage between the common bus and the chassis ground; and
wherein there is a first threshold potential measured by the insulation monitoring device at which maintenance of the isolated earth system is determined to be required.

11. The leakage detection system as claimed in claim 10, wherein the insulation monitoring device is arranged to measure the voltage representative of the voltage between the common bus and the chassis ground; and
wherein there is a second threshold potential measured by the insulation monitoring device at which the isolated earth system is determined to be unsafe.

12. The leakage detection system as claimed in any one of the preceding claims, wherein the isolated earth system comprises a hybrid electric propulsion system.

13. The leakage detection system as claimed in any one of the preceding claims, wherein the leakage detection system is arranged to perform a check for a leakage during initialisation of the aircraft.

14. The leakage detection system as claimed in any one of the preceding claims, power is arranged to be supplied to the common bus by a battery.

15. A method of operating a leakage detection system for an isolated earth system of an aircraft, wherein the leakage detection system comprises:
a common bus;
a plurality of switches;
a chassis ground;
at least one connector;
wherein the at least one connector is arranged to connect at least one of the plurality of switches to at least one component of the isolated earth system;
a switch driver; and
an insulation monitoring device;
wherein the method comprises:
controlling the draw of power from the common bus to the at least one connector using at least one of the plurality of switches;
controlling the plurality of switches between a plurality of configurations using the switch driver;
measuring a voltage representative of a voltage between the common bus and the chassis ground and/or a current representative of a current that flows between the chassis ground and the common bus using the insulation monitoring device when the plurality of switches is in each of the plurality of configurations; and
determining a location of a leakage the voltage representative of the voltage between the common bus and the chassis ground and/or the current representative of the current that flows between the chassis ground and the common bus measured by insulation monitoring device for at least one of the plurality of configurations of the plurality of switches.
